(19) Europäisches Patentamt
European Patent Office
Office européen des brevets

(11) **EP 2 488 885 B1**

(12) **EUROPÄISCHE PATENTSCHRIFT**

(45) Veröffentlichungstag und Bekanntmachung des Hinweises auf die Patenterteilung:
**20.03.2019   Patentblatt 2019/12**

(21) Anmeldenummer: **10768452.4**

(22) Anmeldetag: **11.10.2010**

(51) Int Cl.:
***G01R 31/36*** *(2019.01)*

(86) Internationale Anmeldenummer:
**PCT/EP2010/065171**

(87) Internationale Veröffentlichungsnummer:
**WO 2011/045262 (21.04.2011 Gazette 2011/16)**

(54) **VERFAHREN ZUR BESTIMMUNG UND/ODER VORHERSAGE DER MAXIMALEN LEISTUNGSFÄHIGKEIT EINER BATTERIE**

METHOD FOR DETERMINING AND/OR PREDICTING THE MAXIMUM PERFORMANCE CAPACITY OF A BATTERY

PROCÉDÉ POUR DÉTERMINER ET/OU PRÉDIRE LA CAPACITÉ MAXIMALE D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.10.2009   DE 102009049589**

(43) Veröffentlichungstag der Anmeldung:
**22.08.2012   Patentblatt 2012/34**

(73) Patentinhaber: **Bayerische Motoren Werke Aktiengesellschaft
80809 München (DE)**

(72) Erfinder:
• **BOHLEN, Oliver
80687 München (DE)**
• **ROSCHER, Michael
09419 Thum (DE)**

(56) Entgegenhaltungen:
**DE-A1-102005 050 563**

EP 2 488 885 B1

**Beschreibung**

Die Erfindung bezieht sich auf ein Verfahren zur Bestimmung und/oder Vorhersage der Leistungsfähigkeit einer Batterie, bei dem unter Zugrundelegung eines ein Ersatzschaltbild aufweisenden Modells der Batterie die Leistungsfähigkeit der Batterie vorhergesagt wird. Ein derartiges Verfahren ist aus der DE10337064B4 bekannt.

Mit diesem bekannten Verfahren soll die Hochstrombelastbarkeit einer Batterie, insbesondere einer Starterbatterie für ein Kraftfahrzeug, prognostiziert werden. Diese Startfähigkeitsprognose ermöglicht ihrerseits keine Aussagen über die Leistungsfähigkeit während des sonstigen Betriebs der Batterie. Diese Aussage ist für den Betrieb der Batterie in einem Elektro- und/oder Hybridfahrzeug unerlässlich. Erst die Vorhersage der Leistung, welche die Batterie kurzfristig bereitstellen kann, ohne dabei vorgegebenen Spannungs- und Stromgrenzen zu verletzten, ermöglicht den Einsatz der Batterie bei einem derartigen Fahrzeug.

Es ist bekannt, die Leistungsfähigkeit einer Batterie mit Hilfe von Kennfeldern für die Spannung der belasteten Batterie zu bestimmen. Eingangs-Parameter für diese Spannungs-Kennfelder bei einer bestimmten Lade- oder Entlade-Leistung ist der jeweilige Batteriezustand (Temperatur, Pulsdauer, Ladezustand und/oder Ruhespannung). Siehe den Tagungsbericht Bohlen, O.; Gerschler, J. B.; Sauer, D. U.; Birke, P. & Keller, M. "Robust algorithms for a reliable battery diagnosis - managing batteries in hybrid electric vehicles" EVS, Internat. Electric Vehicle Symp., 22, 2006, 2010-2021]. Die Leistungsdaten stehen dann einem Energiemanagement z.B. eines Hybrid- oder Batteriefahrzeugs zur Verfügung. Ein weiteres bekanntes Verfahren besteht darin, Ersatzinnenwiderstandswerte der Batterie für vorgegebene Prognosezeiträume in Kennfeldern abzulegen oder jeweils im Betrieb zu bestimmen (DE10205120A), aus diesen wird, unter Berücksichtigung der momentanen Ruhespannung und einer angenommenen Belastung mit konstantem Strom, ein Spannungseinbruch berechnet und dieser mit einer vorgegebenen Grenze verglichen.

Ein numerisches Verfahren zur Vorhersage der Leistungsfähigkeit einer Batterie findet sich in DE1020050563.

Die bekannten Verfahren berücksichtigen nicht die vom jeweiligen Batterietyp abhängige Grenze für den maximalen Lade- und minimale Entladespannung.

In Kennfeldern abgelegte Leistungsdaten bilden nicht das dynamische Verhalten von Batterien ab. Dadurch ergeben sich Leistungswerte, die über einen vorgegebenen Prognosezeitraum hinweg zu niedrig und/oder zu hoch sind. Im ersten Fall ergibt sich eine Überlastung der Batterie, im zweiten Fall eine nicht notwendige Überdimensionierung der Batterie. Zudem wirkt sich die Anzahl der Prognosezeiträume direkt proportional auf den Speicherplatzbedarf aus, bei z.B. einer Mikroprozessorberechnung.

Hierbei wird zudem nicht ein innerer Zustand des Modells zu Beginn der Prognose berücksichtigt, der den Einfluss der Belastungsvorgeschichte der Batterie beschreibt. Ebenfalls wird nicht zwischen spannungsbegrenztem und strombegrenztem Fall unterschieden.

Der Erfindung liegt die Aufgabe zu Grunde, ein Verfahren der eingangs genannten Art zu schaffen, das eine realistische Prognose der von der Batterie maximal zur Verfügung stellbaren Leistung liefert.

Die Erfindung löst diese Aufgabe mit den im Patentanspruch 1 angegeben Mitteln. Bei der Erfindung wird zwischen insgesamt vier Fällen unterschieden:

1) Laden mit Spannungsbegrenzung

2) Laden mit Strombegrenzung

3) Entladen mit Spannungsbegrenzung

4) Entladen mit Strombegrenzung

wobei unter Strom-/Spannungsbegrenzung die Berücksichtigung eines batterietypbedingten Maximalwerts für die jeweilige elektrische Belastung (Strom oder Spannung) zu verstehen ist.

Erst mit der erfindungsgemäßen Unterscheidung zwischen strombegrenztem und spannungsbegrenztem Fall ergeben die Batteriemodelle realistische Aussagen über die zu erwartende maximale Leistungsfähigkeit der Batterie über den gesamten Prognosezeitraum hinweg.

Erfindungsgemäß ist in den Fällen 1 und 3 die Spannung konstant und in den Fällen 2 und 4 der Strom konstant.

Führt man beim Ladebetrieb gleichzeitig die Berechnung der Leistungsfähigkeit unter Berücksichtigung des maximalen Ladestroms und der maximalen Ladespannung durch, ergeben sich in der Regel zwei unterschiedliche Werte für die maximale Leistungsfähigkeit. Eine vorteilhafte Weiterbildung der Erfindung besteht darin, den betragsmäßig kleineren Wert der beiden Werte zu verwenden. Dadurch wird keine der zulässigen Betriebsgrenzen der Batterie überschritten. Entsprechendes gilt für den Entladebetrieb.

Eine weitere Verbesserung der Erfindung besteht darin, die Vorgeschichte der Batterie mittels eines Ausgangsspannungswerts zu berücksichtigen. Nach einer längeren Ladephase ist die Doppelschichtkapazität der Batterie bereits polarisiert. Es kann bei derselben Ladespannung weniger Ladeleistung aufgenommen werden, als wenn die Batterie zuvor in Ruhe war oder entladen wurde. Entsprechendes gilt für den Entladefall.

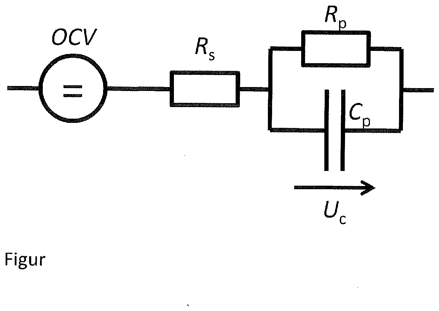

Das dynamische Verhalten, maßgeblich für die kurzzeitige Leistungsfähigkeit von Batterien, wird durch eine Kombination passiver elektrischer Bauelemente (Widerstände, Induktivitäten, Kapazitäten) modelliert und abgebildet. Ein solches Modell ist in der Figur dargestellt und weiter unten im Detail erläutert. Die Werte der Modellparameter sind in der Regel abhängig von der Temperatur, dem Ladezustand, der Stromrichtung (Laden/Entladen) und auch der Stromstärke. Diese Werte sind in einem Batteriemanagementsystem in Kennfeldern abgelegt oder können im Betrieb durch an sich bekannte, nicht näher erläuterte Schätzverfahren ermittelt werden.

Schließlich können die Parameter des Batteriemodells durch einen Parameterschätzer beigestellt und/oder mittels eines Parameterkennfelds gewonnen werden. Dadurch lässt sich die Genauigkeit der Leistungsfähigkeitsprognose weiter verbessern.

In die Prognose der möglichen maximalen Lade-/Entladeleistung fließen neben dem elektrischen Modell die Grenzwerte für die Ströme und die maximalen Lade- bzw. minimale Entladespannungen unter Last ein.

Mit der minimalen Entladespannung ist ein vom Hersteller definierte Spannung an den Klemmen der Batterie gemeint, bei welcher ein Entladevorgang beendet wird. Es handelt sich nicht um ein Zeit- sondern um ein Spannungskriterium, welche das Entladeende definiert.

Das Ende des Prognosezeitraums steht zu Beginn der Berechnung fest. Beispielsweise wird stets eine 10-Sekunden-Prognose berechnet, d.h. der Leistungswert, der 10 Sekunden lang vom momentanen Zeitpunkt aus gerechnet zur Verfügung gestellt werden kann, ohne dass eine Spannungs- oder Stromgrenze überschritten wird.

Hierbei sind, wie bereits ausgeführt, insgesamt vier Fälle zu unterscheiden:

1. Laden mit Spannungsbegrenzung
2. Laden mit Strombegrenzung
3. Entladen mit Spannungsbegrenzung
4. Entladen mit Strombegrenzung

Beim Laden mit Strombegrenzung (Fall 2) steigt die verfügbare Leistung mit der Zeit an, der niedrigste Leistungswert ist der Wert bei t = 0. Für alle anderen Fälle (Fälle 1, 3, 4) sinkt die verfügbare Leistung mit steigender Dauer der Belastung, der niedrigste Leistungswert innerhalb eines Zeitintervalls von $t_x$ Sekunden ist also der Wert bei $t = t_x$

Ob ein Laden oder Entladen durch die Spannung- oder Stromgrenze begrenzt wird, lässt sich nicht a priori ermitteln, die Prognose der maximal verfügbaren Leistung wird daher für beide Fälle berechnet. Die betragsmäßig kleinere Leistung entspricht der tatsächlich verfügbaren maximalen Leistung. Da beim Betrieb der Batterie sowohl die maximal zulässige Lade- als auch Entladeleistung berechnet werden, ergeben sich obige vier Fälle.

Die Leistungsprognose wird dadurch bestimmt, dass die Lösung der Differentialgleichung, die das Batteriemodell (Figur) beschreibt, für diese vier Fälle explizit unter Berücksichtigung der Anfangsbedingungen berechnet wird.

Die Lösungen der Differentialgleichungen, die das Modell aus der Figur beschreiben, sind folgende:

Für Laden oder Entladen mit konstantem Strom (Fall 2 und 4) ergibt sich der zeitliche Verlauf der Spannungsantwort nach Zuschalten einer Last (Laden bzw. Entladen) zu:

$$u(t) = OCV + I_{\lim} \cdot R_s + I_{\lim} \cdot R_p \cdot \left(1 - e^{-t/\tau_1}\right) + U_{C0} \cdot e^{-t/\tau_1} \qquad \tau_1 = R_p \cdot C_p$$

Wobei OCV die Ruhespannung der Batterie beschreibt, $I_{\lim}$ die Stromgrenze (Wert für die Konstantstromladung), $R_s$ den Serienwiderstand der Batterie, $R_p$ den Parallelwiderstand der Batterieimpedanz und $C_p$ den Parallelkondensator der Batterieimpedanz (vgl. Figur) $U_{C0}$ beschreibt die Vorspannung des Kondensators $C_p$ im Ersatzschaltbild, diese kann während des Betriebs durch ein Echtzeitmodell berechnet werden.

Ein solches Echtzeitmodel kann ein elektrisches Ersatzschaltbild sein, das in der einzigen Figur dargestellt ist. Die Spannung $U_c$ über den Kondensator kann dann aus dem Stromverlauf zu jedem Zeitpunkt bestimmt werden. Der Wert von $U_c$ zum Zeitpunkt $t=0$ (der Zeitpunkt, zu dem die Prognose berechnet wird) entspricht $U_{c0}$. Der Vorteil gegenüber anderen Verfahren, in denen $U_{c0}$ nicht berücksichtigt und damit implizit mit $U_{c0} = 0$ angenommen wird, besteht darin, dass durch die Berücksichtigung dieser Spannung eine genauere Vorhersage möglich ist.

Für Laden oder Entladen mit konstanter Spannung (Fall 1 und 3) ergibt sich die Stromantwort:

$$i(t) = \frac{U_{\text{lim}} - OCV}{R_{\text{s}} + R_{\text{p}}} \cdot \left(1 + \frac{R_{\text{p}}}{R_{\text{s}}} e^{-t/\tau_{\text{U}}}\right) - \frac{U_{C0}}{R_{\text{s}}} \cdot e^{-t/\tau_{\text{U}}} \qquad \tau_{\text{U}} = \frac{R_{\text{s}} \cdot R_{\text{p}}}{R_{\text{s}} + R_{\text{p}}} \cdot C_{\text{p}}$$

wobei $U_{\text{lim}}$ die Spannungsgrenze, d.h. den Wert für die Ladung mit der maximal zulässigen konstanten Spannung beschreibt.

Die jeweiligen und im Vergleich zueinander gesetzten Leistungswerte ergeben sich gleich dem Produkt aus Strom und Spannung, also $P_{\text{prog}}$ = u(t) * $I_{\text{lim}}$ für die strombegrenzten Fälle (2 und 4), $P_{\text{prog}}$ = i(t) * $U_{\text{lim}}$ für die spannungs-begrenzten Fälle (1 und 3).

Die Modellparameter $R_{\text{s}}$, $R_{\text{p}}$ und $C_{\text{p}}$ für den momentanen Betriebszustand werden von einem an sich bekannten Parameterschätzer und/oder einem ebenfalls üblichen Parameterkennfeld zur Verfügung gestellt. Der Wert der Ruhespannung OCV wird, wie an sich bekannt, von einem Zustandsschätzer oder aus Kennfeldern zur Verfügung gestellt. Der Wert $U_{\text{co}}$ der Vorspannung des Kondensators $C_{\text{p}}$ wird anhand eines in Echtzeit berechneten Modells bestimmt. Daraus werden die Spannungs- und Stromwerte für die strom- und spannungsbegrenzten Lade- und Entladefälle (Fall 1-4) für den Prognosezeitpunkt $t_{\text{prog}}$ berechnet (Sonderfall Laden mit Strombegrenzung: Berechnung für $t_{\text{prog}}$ = 0).

Wie oben erwähnt ist steigt beim Laden an der Stromgrenze die Leistungswerte, im Gegensatz zu den drei anderen Fällen, mit fortschreitender Belastungsdauer an.

Damit lassen sich kontinuierlich die maximale Leistungen für beliebige Prognosezeiträume explizit mit guter Genauigkeit berechnen, da das zu Grunde gelegte Batteriemodell die Eigenschaften der Batterie und insbesondere die Anfangsbedingungen ($U_{\text{co}}$) und die unterschiedlichen Randbedingungen (Strom und Spannungsbegrenzung) explizit berücksichtigt.

Der Rechen- und Speicherbedarf ist unabhängig von der Zahl der Prognosezeiträume und bietet so die Möglichkeit mit einem Minimum an Applikationsparametern die Leistungsfähigkeit der Batterie bestmöglich zu nutzen.

Für die korrekte Berechnung der Leistungsprognose muss ein Sonderfall berücksichtigt werden:
Für das Laden einer Batterie steigt die Lade-Leistung kontinuierlich mit steigenden Stromwerten, da auch die Spannung entsprechend steigt. Beim Entladen sinkt jedoch die Spannung mit steigenden Entladestromwerten, so dass sich die Entladeleistung zunächst erhöht, ab einer bestimmten Stromstärke aber wieder abnimmt, wenn die Spannung unter Last kleiner wird als die halbe Ruhespannung der Batterie.

Wenn die Spannungsprognose für den Fall 4 (s.o.) kleiner ist als die halbe Ruhespannung (OCV/2), wird der zugehörige Leistungswert verworfen, da dieser kleiner ist als die maximal verfügbare Entladeleistung. Stattdessen wird nur die Leistungsprognose für Fall 3 berechnet, wobei die vorgegebene Spannungsgrenze durch OCV/2 ersetzt wird, falls sie unterhalb diese Wertes liegt (also Ulim >= OCV/2).

Dies sei an Hand eines Ausführungsbeispiels erläutert:
In einem nicht dargestellten Batteriemanagementsystem werden die Größen Spannung, Strom und Temperatur ständig gemessen und ggf. weitere Batteriegrößen wie Ladezustand und Alterungszustand ermittelt.

Zu jedem Zeitpunkt werden ebenfalls die Spannungs- und Stromgrenzen der Batterie ($U_{\text{lim}}$, $I_{\text{lim}}$) bestimmt (z.B. aus einer Tabelle, als Konstante oder als Funktion von Ladezustand und/oder Temperatur und/oder Alterungsgrad und/oder der Belastungshistorie). Die für die Leistungsprognose herangezogenen Grenzen können dabei durch einen Faktor oder Offset aus den Fehlergrenzen berechnet werden. Dabei liegen die Grenzen in der Regel enger (also niedriger beim Laden und höher beim Entladen), so dass keine Fehlerreaktion erfolgt, wenn die prognostizierte Spannung oder Strom durch Modell- und/oder Messungenauigkeiten geringfügig von den realen Werten abweicht.

Die Parameter $R_{\text{s}}$, $R_{\text{p}}$ $C_{\text{p}}$ des der Figur gezeigten Batteriemodells werden ebenfalls kontinuierlich bestimmt, z.B in dem sie aus einer Tabelle als Funktion von Ladezustand und/oder Temperatur und/oder Alterungsgrad und/oder der Belastungshistorie und/oder Stromwert ausgelesen oder in dem sie durch ein Schätzverfahren oder durch eine Kombination aus beidem bestimmt werden

Mit Hilfe des beschriebenen Verfahrens werden daraus Prognosewerte für die verfügbare Batterieleistung $P_{\text{prog}}$ für Lade- und Entladevorgänge berechnet. Diese Prognosewerte können für unterschiedliche Prognosehorizonte bestimmt werden, so kann z.B. stets eine Kurzzeitprognose (z.B. 1 sec Prognosehorizont) und eine Langzeitprognose eine Kurzzeitprognose (z.B. 10 sec Prognosehorizont) berechnet werden.

Diese Leistungsprognose-Werte werden an die ebenfalls nicht gezeigte Betriebsstrategie-Einstellvorrichtung übermittelt. Die Betriebsstrategie-Einstellvorrichtung kann diese Werte z.B. für die Regelung der Elektrischen Maschine, für die Aufteilung von elektrischer und mechanischer Leistung beim Beschleunigen und/oder Bremsen und/oder für das Zu- oder Abschalten von elektrischen Verbrauchern heranziehen.

Insbesondere kann die Leistungsprognose für eine vorausschauende Regelung der Leistungsflüsse verwendet werden. Da die verfügbare Leistung im Vorhinein bekannt ist, kann verhindert werden, dass sehr schnelle und abrupte Eingriffe auf den Leistungsfluss notwendig werden, die ansonsten zu einem unerwünschten Fahrerlebnis führen (z.B. Ruckeln, fühl- und oder hörbarer Leistungseinbruch beim Beschleunigen etc.)

Wenn z.B. während eines Beschleunigungsvorgangs die Prognose für die über 10 sec verfügbare Leistung geringer ist als die kurzzeitig verfügbare Leistung, so kann entweder die Leistungs von vorneherein unter die kurzzeitig mögliche begrenzt werden, um einen fühlbaren Leistungseinbruch zu vermeiden, oder die Leistung wird kontinuierlich reduziert in einem Maße, die vom Fahrer nicht spürbar ist und daher nicht als unangenehm empfunden wird. Rechtzeitig vor Erreichen der Leistungsgrenze wird der niedrigere Zielwert erreicht.

**Patentansprüche**

1. Verfahren zur Bestimmung und/oder Vorhersage der maximalen Leistungsfähigkeit einer Batterie, bei dem unter Zugrundelegung eines Modells der Batterie, basierend auf einem elektrischen Ersatzschaltbild, die maximale Leistungsfähigkeit der Batterie vorhergesagt wird, **dadurch gekennzeichnet,**
**dass** die maximale Leistung der Batterie für einen definierten Prognosezeitraum und für die hinsichtlich Lade- oder Entladebetrieb unterschiedene Betriebsart und unter Berücksichtigung der maximal zulässigen Betriebsspannung und des maximal zulässigen Betriebsstroms für die vier Fälle

   - Laden mit konstanter Spannung,
   - Laden mit konstantem Strom,
   - Entladen mit konstanter Spannung und
   - Entladen mit konstantem Strom

durch explizite Berechnung der Lösung einer das Modell beschreibenden Differentialgleichung prognostiziert wird.

2. Verfahren nach Anspruch 1, **dadurch gekennzeichnet, dass** die Leistungsfähigkeit $P_{prog}$ der Batterie für den Lade-/Entladebetrieb gleich dem betragsmäßig kleineren Wert der gleichzeitig ermittelten maximalen Leistungswerte für den maximal zulässigen Lade-/Entladestrom und der maximal zulässigen Lade-/Entladespannung ist.

3. Verfahren nach Anspruch 1 oder 2, **dadurch gekennzeichnet, dass** die Belastungsvorgeschichte der Batterie mittels eines berechneten Vorspannungswerts $U_{c0}$ berücksichtigt wird.

4. Verfahren nach einem der vorhergehenden Ansprüche, **dadurch gekennzeichnet, dass** die Parameter des Batteriemodells durch einen Parameterschätzer beigestellt werden.

5. Verfahren nach einem der Ansprüche 1 bis 3, **dadurch gekennzeichnet, dass** die Parameter des Batteriemodells mittels eines Parameterkennfelds gewonnen werden.

**Claims**

1. A method for determining and/or predicting the maximum performance capacity of a battery, in which, using a model of the battery, based on an electric equivalent circuit diagram, the maximum performance capacity of the battery is predicted, **characterised in that**
the maximum performance of the battery is forecast for a defined prognosis period and for the different operating modes with respect to charging or discharging operation, taking into consideration the maximum permissible operating voltage and the maximum permissible operating current for the following four cases

   - charging with constant voltage,
   - charging with constant current,
   - discharging with constant voltage, and
   - discharging with constant current

by explicit calculation of the solution of a differential equation describing the model.

2. A method according to claim 1, **characterised in that** the performance capacity $P_{prog}$ of the battery for the charging/discharging operation is equal to the value, in terms of amount, that is the lesser of the simultaneously determined maximum performance values for the maximum permissible charging/discharging current and the maximum permissible charging/discharging voltage.

3. A method according to claim 1 or 2, **characterised in that** the load history of the battery is taken into consideration by means of a calculated bias value $U_{c0}$.

4. A method according to any one of the preceding claims, **characterised in that** the parameters of the battery model are provided by a parameter estimator.

5. A method according to any one of claims 1 to 3, **characterised in that** the parameters of the battery model are obtained by means of a parameter map.

**Revendications**

1. Procédé permettant de déterminer et/ou de prévoir la capacité maximum d'une batterie selon lequel on prévoit la capacité maximum de la batterie en se basant sur un modèle de la batterie, fondé sur un circuit équivalent, **caractérisé en ce que**
   la puissance maximum de la batterie pendant une durée de prévision définie et pour différents modes de fonctionnement concernant le fonctionnement de charge ou de décharge et en prenant en considération la tension de fonctionnement maximum admissible et le courant de fonctionnement maximum admissible pour les quatre cas suivants :

   - charge à tension constante,
   - charge à courant constant,
   - décharge à tension constante, et
   - décharge à courant constant,

   est prévue par calcul explicite de la solution d'une équation différentielle décrivant le modèle.

2. Procédé conforme à la revendication 1,
   **caractérisé en ce que**
   la capacité $P_{prog}$ de la batterie pour le fonctionnement de charge/décharge est égale à la plus petite valeur de la valeur de la puissance maximum déterminée simultanément pour le courant de charge/décharge maximum admissible et la tension de charge/décharge maximum admissible.

3. Procédé conforme à la revendication 1 ou 2,
   **caractérisé en ce que**
   l'historique de charge de la batterie et prise en considération au moyen d'une valeur de tension préalable $U_{co}$ calculée.

4. Procédé conforme à l'une des revendications précédentes,
   **caractérisé en ce que**
   les paramètres du modèle de batterie sont fournis par un estimateur de paramètres.

5. Procédé conforme à l'une des revendications 1 à 3,
   **caractérisé en ce que**
   les paramètres du modèle de batterie sont obtenus au moyen d'un champ caractéristique de paramètres.

Figur

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10337064 B4
- DE 10205120 A
- DE 1020050563

**In der Beschreibung aufgeführte Nicht-Patentliteratur**

- **BOHLEN, O. ; GERSCHLER, J. B. ; SAUER, D. U. ; BIRKE, P. ; KELLER, M.** Robust algorithms for a reliable battery diagnosis - managing batteries in hybrid electric vehicles. *EVS, Internat. Electric Vehicle Symp.,* 2006, vol. 22, 2010-2021